# EUROPÄISCHE PATENTSCHRIFT

(11) **EP 4 127 744 B1**
(45) Veröffentlichungstag und Bekanntmachung des Hinweises auf die Patenterteilung: **08.01.2025**
(21) Anmeldenummer: 21716648.7
(22) Anmeldetag: 29.03.2021
(51) Int. Cl.: G01R 31/08, G01R 31/12, G01R 31/14

(54) **ELEKTRISCHE SCHALTUNGSANORDNUNG**
ELECTRICAL CIRCUIT
CIRCUIT ÉLECTRIQUE

(30) Priorität: 31.03.2020 AT 812020
(43) Veröffentlichungstag der Anmeldung: 08.02.2023
(73) Patentinhaber: BAUR GmbH, 6832 Sulz (AT)
(72) Erfinder: HEINZLE, Stefan, 6900 Bregenz (AT); HUPP, Mathias, 6774 Tschagguns (AT); BAWART, Manfred, 6832 Sulz (AT); JENNY, Martin, 6850 Dornbirn (AT)
(74) Vertreter: Torggler & Hofmann Patentanwälte - Rankweil
(86) Internationale Anmeldenummer: PCT/EP2021/058094
(87) Internationale Veröffentlichungsnummer: WO 2021/198146

(56) Entgegenhaltungen:
- EP-A1- 0 769 150
- EP-A1- 1 018 028
- EP-A1- 2 204 660
- EP-A1- 2 863 553
- EP-A1- 2 866 041
- CN-U- 209 264 895
- DE-A1- 102011 006 098
- US-A1- 2016 161 543
- ZHANG MIN ET AL: "Experimental Study on the Effectiveness of Partial Discharge Detection in Switchgear Based on Non-contact UHF sensing", 2019 IEEE SUSTAINABLE POWER AND ENERGY CONFERENCE (ISPEC), IEEE, 21 November 2019 (2019-11-21), pages 2808 - 2811, XP033696867, DOI: 10.1109/ISPEC48194.2019.8975005

## Beschreibung

Die Erfindung bezieht sich auf eine elektrische Schaltungsanordnung zum Verbinden einer elektrischen Messeinrichtung, welche zur Messung von Teilentladungen in einem Stromnetz mit einer im Bereich von 1kV bis 69kV liegenden Betriebsspannung dient und einen A/D-Wandler zur Umwandlung eines gemessenen Spannungsimpulses in ein digitales Signal und eine Mikroprozessoreinheit zur Auswertung des digitalen Signals aufweist, mit einem Messausgang eines kapazitiven Spannungsprüfsystems einer Schaltanlage für das Stromnetz mit der im Bereich von 1kV bis 69kV liegenden Betriebsspannung.

Im Weiteren bezieht sich die Erfindung auf eine Messanordnung zur Messung von Teilentladungen an einem Messausgang eines kapazitiven Spannungsprüfsystems einer Schaltanlage für ein Stromnetz mit einer im Bereich von 1kV bis 69kV liegenden Betriebsspannung, wobei die Messanordnung einen A/D-Wandler zur Umwandlung eines gemessenen Spannungsimpulses in ein digitales Signal und eine Mikroprozessoreinheit zur Auswertung des digitalen Signals aufweist.

Im Weiteren bezieht sich die Erfindung auf ein Messsystem zur Lokalisierung des Ortes einer Teilentladung in einem Stromnetz mit einer im Bereich von 1kV bis 69 kV liegenden Betriebsspannung.

Teilentladungsmessungen werden an Hoch- und Mittelspannungsleitungen zu Diagnosezwecken durchgeführt. Insbesondere kann ein Auftreten von Teilentladungen auf Isolationsdefekte hinweisen, welche im Laufe der Zeit zu Isolationsfehlern führen können.

Bevorzugt ist eine Messung von Teilentladungen ohne ein Erfordernis, das Kabel hierzu zuvor von Spannung freizuschalten. Zu diesem Zweck ist es bekannt, sogenannte HFCT(High Frequency Current Transformer)-Sensoren einzusetzen. Es handelt sich hierbei um Stromwandler, die zwei halbringförmige Teile aufweisen, welche mit einem Draht umwickelt sind (Rogowski-Spule) und zu einem Ring geschlossen werden, der um eine vom Kabelschirm des zu vermessenden Kabels ausgehende Erdverbindungsleitung gelegt wird. Bei einem Auftreten von Teilentladungen, bei welchen es zu Stromimpulsen kommt, die entlang der Erdverbindungsleitung abfließen, werden entsprechende Spannungsimpulse im HFCT-Sensor hervorgerufen, die von einer angeschlossenen Messeinrichtung detektiert und ausgewertet werden können. Eine solche Messeinrichtung weist u.a. einen A/D-Wandler zur Umwandlung eines gemessenen Spannungsimpulses in ein digitales Signal und eine Mikroprozessoreinheit zur Verarbeitung des digitalen Signals auf. Zur weiteren Auswertung ist meist ein separater Computer angeschlossen. Es werden bei dieser Auswertung u.a. Störsignale ausgefiltert, um eine Aussage über auftretende Teilentladungen zu erhalten.

Bekannt ist es hierbei auch, ein zusätzliches Synchronisierungssignal zu erzeugen, welches mit der Phase der Wechselspannung synchronisiert ist, um die Phasenlage von erfassten Teilentladungsimpulsen zu ermitteln, wodurch zusätzliche Aussagen über mögliche Ursachen der Teilentladungen gemacht werden können.

Eine Anwendung von HFCT-Sensoren zur Teilentladungsmessung ist beispielsweise in "Application of HFCT and UHF Sensors in OnLine Partial Discharge Measurements for Insulation Diagnosis of High Voltage Equipment", Fernando Älvarez et al., Sensors 2015, 15, 7360-7387 beschrieben.

Solche Online-Teilentladungsmessungen werden im Bereich von Schaltanlagen von Hoch- und Mittelspannungsnetzen durchgeführt. Dies ist aber nur an hierfür geeigneten Schaltanlagen möglich. Beispielsweise ist ein Online-Anschluss eines HFCT-Sensors nicht möglich, wenn die Erdverbindung des Kabelschirms innerhalb der Schaltanlage ausgeführt und nicht zugänglich ist, ohne die Schaltanlage von Spannung freizuschalten, oder wenn die Erdverbindung des Kabelschirms fest mit dem Gehäuse der Schaltanlage verbunden ist. Da das Gehäuse der Schaltanlage üblicherweise auch separat mit Erde verbunden ist, erfolgt im letzteren Fall keine definierte Ableitung der durch Teilentladungen hervorgerufenen Stromimpulse über die Erdverbindung des Kabelschirms. In solchen Fällen muss, um einen HFCT-Sensor zu installieren, zunächst eine Spannungsfreischaltung erfolgen, was mit einem entsprechenden Aufwand verbunden ist. Alternative Möglichkeiten zur Messung von Teilentladungen wären daher vorteilhaft.

Es wurden hierzu bereits Messeinrichtungen, welche für den Anschluss an HFCT-Sensoren vorgesehen sind, an einem Messausgang eines kapazitiven Spannungsprüfsystems (VDS) einer Schaltanlage eines Stromnetzes mit einer im Bereich von 1kV bis 52kV liegenden Betriebsspannung angeschlossen. Solche kapazitive Spannungsprüfsysteme in Schaltanlagen für Stromnetze mit einer im Bereich von 1kV bis 52kV liegenden Betriebsspannung sind in der Norm IEC 61243-5:1997 normiert. Ein derartiges Spannungsprüfsystem weist einen an das zu prüfende spannungsführende Bauteil angeschlossenen Koppelkondensator auf, der über eine koaxiale Verbindungsleitung einer definierten Länge mit dem i.A. als Anschlussbuchse ausgebildeten Messausgang verbunden ist. Der Schirm der koaxialen Verbindungsleitung ist mit Erde verbunden. Die koaxiale Verbindungsleitung bildet somit eine weitere Kapazität aus. Wird nun an die Anschlussbuchse eine Messeinrichtung angeschlossen, welche zum Anschluss an einen HFCT-Sensor vorgesehen ist, so können damit nur im Bereich der Schaltanlage und in der näheren Umgebung der Schaltanlage auftretende Teilentladungen erfasst werden, jedoch keine weiter entfernt auftretende Teilentladungen.

Ein gleich aufgebautes Spannungsprüfsystem kann auch für Spannungen bis 69kV eingesetzt werden. Je nach Definition wird eine solche Spannung immer noch als Mittelspannung bezeichnet.

Um die Stelle des Kabels zu lokalisieren, an welcher Teilentladungen auftreten, ist es bekannt, eine Messeinrichtung zur Messung von Teilentladungen über einen HFCT-Sensor an das Kabel zu koppeln und den zeitlichen Abstand zwischen einem Teilentladungspuls und der zeitlich verzögerten Reflexion des Teilentladungspulses vom entfernten Kabelende zu erfassen. Aus der Laufzeitdifferenz zwischen dem Teilentladungspuls und dem von der Reflexion am entfernten Kabelende herrührenden Puls kann bei bekannter Ausbreitungsgeschwindigkeit des Pulses der Abstand des Ortes der Teilentladung vom Kabelende (= Länge des Kabels zwischen der Stelle des Kabels, an dem die Teilentladung auftritt, und dem Kabelende) ermittelt werden. Dieses Verfahren wir auch als TDR-basiertes Zeitmessverfahren bezeichnet.

Bei sehr langen Kabeln kann der am Kabelende reflektierte Puls aber so stark gedämpft sein, dass er nicht bzw. nicht zuverlässig detektiert wird. Gerade für solche Fälle oder für Kabel mit kompliziertem Reflexionsverhalten, wie bei T-verzweigten oder mehrfach verzweigten Kabeln, ist es bekannt Messeinrichtungen zur Messung von Teilentladungen an zwei Kabelenden (bei verzweigten Kabeln auch an mehr als zwei Kabelenden) über HFCT-Sensoren an das Kabel zu koppeln. Für die an den Kabelenden angeordneten Messeinrichtungen wird eine gemeinsame hochgenaue Zeitbasis hergestellt, d.h. die Messeinheiten weisen synchronisierte Zeiterfassungseinheiten auf. Eine solche Synchronisation kann beispielsweise GPS-basiert erfolgen. Es wird dann die Differenz der Laufzeiten ausgewertet, welche ein Teilentladungspuls zu einer jeweiligen Messeinrichtung benötigt. Anhand der bekannten Ausbreitungsgeschwindigkeit der Teilentladungspulse kann die Differenz der durchlaufenen Kabellängen und somit der Ort der Teilentladung bestimmt werden.

Aus der EP 2 204 660 A1 geht eine Messeinrichtung zur Messung von Teilentladungen u.a. an Hochspannungskabeln hervor. Ein Messpunkt ist über einen Koppelkondensator mit dem Prüfling und über eine Messimpedanz mit der Masse verbunden. Das am Messpunkt anliegende Signal wird von einem Verstärker verstärkt und mittels unterschiedlicher Bandpassfilter gefiltert. Durch diese Messeinrichtung soll eine Verbesserung gegenüber Störsignalen durch externe Störquellen erreicht werden und eine Trennung mehrerer überlagerter Teilentladungsquellen verbessert werden. Aus dieser Schrift geht somit eine Messeinrichtung zur Messung von Teilentladungen hervor, das Problem der Verbindung einer solchen Messeinrichtung mit einem Messausgang eines kapazitiven Spannungsprüfsystems einer Schaltanlage ist aber nicht angesprochen. Dies gilt auch in analoger Weise für die DE 10 2011 006 098 A1, welche eine Messeinrichtung zur Feststellung von Teilentladungen im Isolationssystem von rotierenden elektrischen Maschinen beschreibt. Es ist hier an jeder der Statorwicklungen ein Koppler als Hochpass angeschlossen. Dem Koppler ist eine Adaptereinrichtung nachgeschaltet, die einen Hochpassfilter und einen Tiefpassfilter aufweist.

Bekannt ist auch die Messung von Teilentladungen im Offline-Betrieb. Dabei ist die Betriebsspannung abgekoppelt und es wird das Kabel mit einer aus einer separaten Hochspannungsquelle stammenden Hochspannung belastet. Die Auskopplung von Teilentladungspulsen, um diese von einer Messeinrichtung zu erfassen, erfolgt hier üblicherweise nicht mit HFCT-Sensoren sondern mit einer Schaltungsanordnung nach der Norm IEC 60270, wobei sehr große und schwere Koppelkondensatoren im nF-Bereich eingesetzt werden.

Aufgabe der Erfindung ist es, die Möglichkeiten zur Messung von Teilentladungen in Mittelspannungsnetzen im Online-Betrieb, also ohne eine vorausgehende Abschaltung der Spannung, zu erweitern. Erfindungsgemäß gelingt dies durch eine elektrische Schaltungsanordnung mit den Merkmalen des Anspruchs 1 bzw. durch eine Messanordnung mit den Merkmalen des Anspruchs 10 bzw. durch ein Messsystem mit den Merkmalen des Anspruchs 12.

Eine elektrische Schaltungsanordnung gemäß der Erfindung weist einen Frequenzgang-Anpassungswiderstand, der zwischen einer Eingangsleitung, insbesondere Koaxialleitung, welche zur Verbindung mit dem spannungsführenden Pol des Messausgangs des kapazitiven Spannungsprüfsystems dient, und Erde geschaltet ist, sowie einen dem Frequenzgang-Anpassungswiderstand nachgeschalteten Hochpassfilter auf. Über eine solche Schaltungsanordnung kann in vorteilhafter Weise eine Messeinrichtung, welche einen A/D-Wandler zur Umwandlung eines gemessenen Spannungsimpulses in ein digitales Signal und eine Mikroprozessoreinheit zur Auswertung des digitalen Signals aufweist, mit einem Messausgang eines kapazitiven Spannungsprüfsystems (VDS) einer Schaltanlage für Mittelspannungsnetze verbunden werden, wobei der Messausgang beispielsweise als Anschlussbuchse ausgebildet ist.

Durch den Frequenzgang-Anpassungswiderstand kann der in Verbindung mit dem kapazitiven Spannungsprüfsystem sich ergebende Frequenzgang zu niedrigeren Frequenzen verschoben werden, wodurch auch Teilentladungs-Pulse mit niedrigeren Frequenzanteilen detektiert werden können. Solche Teilentladungs-Pulse mit niedrigeren Frequenzanteilen werden erhalten, wenn Teilentladungen nicht in der näheren Umgebung des Messortes sondern weiter entfernt auftreten, wobei durch die Tiefpasscharakteristik des Kabels die hohen Frequenzanteile des Teilentladungsimpulses eine Änderung oder Dispersion erfahren. Im Weiteren können durch den Einsatz des nachgeschalteten Hochpassfilters Frequenzen unterhalb eines zulässigen Frequenzbereiches ausreichend ausgefiltert werden, wodurch eine aussagekräftige Auswertung des Messsignals erst ermöglicht wird.

Ein kapazitives Spannungsprüfsystem (VDS) weist insbesondere einen an das spannungsführende Teil angeschlossenen Koppelkondensator und eine an den anderen Anschluss des Koppelkondensators angeschlossene Koaxialleitung auf, welche eine weitere Kapazität ausbildet. Der Schirm der

Koaxialleitung ist mit Erde verbunden. Am vom Koppelkondensator abgelegenen Ende der Koaxialleitung befindet sich der Messausgang, der beispielsweise als Anschlussbuchse ausgebildet ist, wie dies häufig bevorzugt ist.

Im Rahmen dieser Schrift wird als Mittelspannung der Spannungsbereich von 1kV bis 69kV bezeichnet. Wenn im Weiteren also von Mittelspannung die Rede ist, so geht es um eine Spannung in diesem Spannungsbereich. Ein "Mittelspannungsnetz" bezeichnet demgemäß ein Stromnetz mit einer Betriebsspannung in diesem Bereich.

Dem Frequenzgang-Anpassungswiderstand ist günstigerweise außerdem ein Tiefpassfilter nachgeschaltet. Durch die elektrische Schaltungsanordnung in Verbindung mit dem kapazitiven Spannungsprüfsystem kann dadurch insgesamt ein Frequenzgang erzielt werden, der zumindest weitgehend demjenigen entspricht, wie er erhalten wird, wenn die Messeinrichtung direkt an einen HFCT-Sensor angeschlossen wird.

Durch die erfindungsgemäße Schaltungsanordnung wird es somit ermöglicht, eine Messeinrichtung, die zum Einsatz mit HFCT-Sensoren vorgesehen ist, in vorteilhafter Weise an Messausgängen von kapazitiven Spannungsprüfsystemen von Schaltanlagen für Mittelspannungsnetze einzusetzen, wobei der vorteilhafte erweiterte Frequenzbereich für Teilentladungsmessungen abgebildet wird.

Dem Hochpassfilter und Tiefpassfilter ist vorteilhafterweise ein Verstärker nachgeschaltet, wodurch im Weiteren eine Anpassung des Pegels des Signals an einen für die Messeinrichtung vorteilhaften Eingangspegel angepasst werden kann. Vorzugsweise ist dem Verstärker ein Impedanz-Anpassungswiderstand zur Impedanzanpassung an den Eingangswiderstand der Messeinrichtung nachgeschaltet, um eine Leistungsanpassung (=Impedanzanpassung) durchzuführen.

Eine Messanordnung zur Messung von Teilentladungen an einer Anschlussbuchse eines kapazitiven Spannungsprüfsystems einer Schaltanlage für Mittelspannungsnetze gemäß der Erfindung weist eine erfindungsgemäße elektrische Schaltungsanordnung sowie eine nachgeschaltete Messeinrichtung umfassend einen A/D-Wandler zur Umwandlung eines gemessenen Spannungsimpulses in ein digitales Signal und eine Mikroprozessoreinheit zur Auswertung des digitalen Signals auf.

Bei der Messanordnung gemäß der Erfindung kann es sich um ein einzelnes Gerät (also mit einem einzigen Gehäuse) oder um zwei oder mehr Geräte in separaten Gehäusen handeln. Insbesondere kann im letzteren Fall in einem ersten Gehäuse die Schaltungsanordnung (enthaltend den Frequenzgang-Anpassungswiderstand und den nachgeschalteten Hochpassfilter) und in einem separaten Gehäuse die Messeinrichtung umfassend den A/D-Wandler und die Mikroprozessoreinheit untergebracht sein, wobei zwischen den beiden Geräten mindestens eine elektrische Verbindungsleitung verläuft.

Durch die Erfindung werden auch Messungen in Situationen ermöglicht, die bei einer Messung mit HFCT-Sensoren nicht erfasst werden können. Ein Beispiel besteht darin, dass das Kabel, welches an einem Ende mit der Betriebsspannung des Mittelspannungsnetzes verbunden ist, am anderen Ende offen ist. Über einen HFCT-Sensor wird in solchen Situationen kein Signal erhalten, durch das erfindungsgemäße Verfahren bzw. mittels der erfindungsgemäßen Einrichtung aber schon. Analoges gilt bei Kabeln, deren Kabelschirm am Ende der Schaltanlage nicht mit Erde verbunden ist.

Bei einer vorteilhaften Weiterbildung einer Messanordnung gemäß der Erfindung weist die Messanordnung eine Zeiterfassungseinheit zur Erfassung der zeitlichen Differenz zwischen von der Messanordnung erfassten Spannungspulsen auf. Wenn die Messanordnung an einem Kabelende an einen Messausgang eines kapazitiven Spannungsprüfsystems angeschlossen ist, kann damit der zeitliche Abstand zwischen dem direkt von der Stelle der Teilentladung zur Messanordnung laufenden Spannungspuls und dem von der Stelle der Teilentladung zum entfernten Kabelende laufenden und an diesem entfernten Kabelende zurückreflektierten Spannungspuls erfasst werden. Aus diesem zeitlichen Abstand und der bekannten Ausbreitungsgeschwindigkeit des Spannungspulses kann der Ort der Teilentladung ermittelt werden.

Die Ermittlung des Ortes der Teilentladung aus der zeitlichen Differenz zwischen dem direkten Teilentladungspuls und dem am entfernten Kabelende reflektierten Teilentladungspuls ist an sich bekannt. Durch die Erfindung wird aber eine einfachste Ankopplung der Messanordnung ohne Betriebsspannungsunterbrechung ermöglicht, wobei eine maximale Sicherheit für das Messpersonal erreicht wird. Es ist kein Schalten und Hantieren im Hochspannungsbereich erforderlich. Es wird eine Distanzmessung ermöglicht, ohne dass ein zusätzlicher Teilentladungssensor montiert werden müsste.

Insbesondere zur Messung an sehr langen Kabeln oder an Kabeln mit kompliziertem Reflexionsverhalten (T-verzweigten oder mehrfach verzweigten Kabeln) ist es vorteilhaft, ein Messsystem zur Lokalisierung des Ortes einer Teilentladung in einem Stromnetz mit einer im Bereich von 1kV bis 69kV liegenden Betriebsspannung gemäß der Erfindung vorzusehen, welches mindestens zwei erfindungsgemäße Messanordnungen zur Messung von Teilentladungen an einem jeweiligen Messausgang von kapazitiven Spannungsprüfsystemen aufweist, wobei die kapazitiven Spannungsprüfsysteme an einem jeweiligen Ende eines Kabels des Stromnetzes angeordnet sind. Die Messanordnungen weisen miteinander synchronisierbare Zeiterfassungseinheiten auf. Mittels dieser Zeiterfassungseinheiten kann eine Differenz der Laufzeiten eines von einer Teilentladung hervorgerufenen Spannungspulses zur jeweiligen Messanordnung erfasst werden.

Aus diesen Laufzeitmessungen kann die Stelle des Kabels, an welcher eine Teilentladung auftritt, ermittelt werden. Bei T-verzweigten Kabeln können hierbei an mehreren Kabelenden solche Messanordnungen an Messausgänge von kapazitiven Spannungsprüfsystemen angeschlossen werden.

Durch die Erfindung wird eine einfachste Ankopplung der Messanordnungen ohne Betriebsspannungsunterbrechung ermöglicht, wobei eine maximale Sicherheit für das Messpersonal erreicht wird. Es ist kein Schalten und Hantieren im Hochspannungsbereich erforderlich. Es wird eine Online-Teilentladungs-Fehlerdistanzmessung auch an langen Kabelsystemen sowie an T-verzweigten Kabeln ermöglicht. Bei T-verzweigten Kabeln kann hierbei die Messanordnung auch bei Kabelenden mit offenem Stromkreis eingesetzt werden. Ein HFCT-Sensor wäre dagegen bei offenem Stromkreis nicht anwendbar.

Weitere Vorteile und Einzelheiten der Erfindung werden im Folgenden anhand der beiliegenden Zeichnung erläutert. In dieser zeigen:
- Fig. 1: eine schematische Darstellung einer Messanordnung enthaltend eine Schaltungsanordnung gemäß der Erfindung;
- Fig. 2: eine Darstellung des Frequenzgangs;
- Fig. 3: ein zweites Ausführungsbeispiel der Erfindung;
- Fig. 4: ein Symbolbild zur Erläuterung eines dritten Ausführungsbeispiels der Erfindung;
- Fig. 5: eine schematische Darstellung eines Ausführungsbeispiels eines Messsystems gemäß der Erfindung;
- Fig. 6: eine schematische Darstellung eines T-verzweigten Kabels.

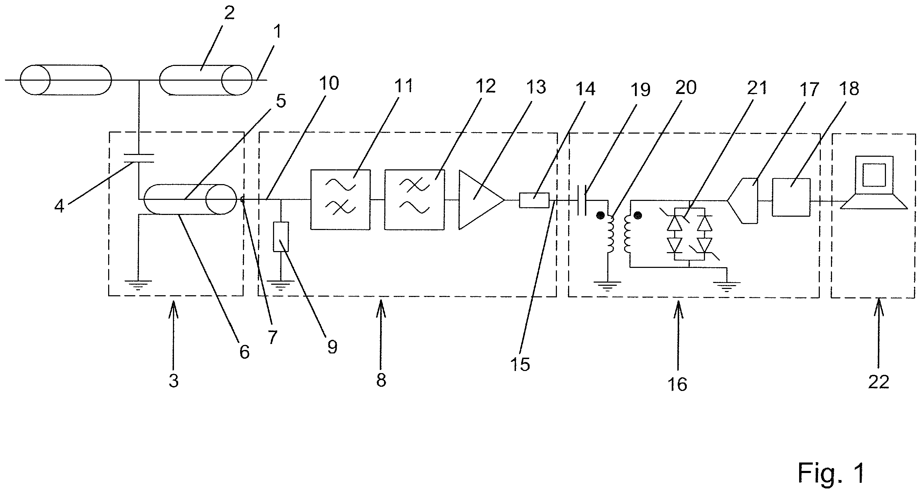

Ein erstes Ausführungsbeispiel der Erfindung wird im Folgenden anhand Fig. 1 erläutert.

In Fig. 1 ist schematisch ein Leiter 1 eines Mittelspannungsnetzes dargestellt. Am Leiter 1 liegt somit eine Spannung im Bereich von 1 kV bis 69 kV an. Ein häufiger Spannungsbereich beträgt 6 kV bis 36 kV. Ein den Leiter 1 umgebender Kabelschirm 2 ist angedeutet.

Der Leiter 1 ist in einer Schaltanlage angeordnet. Mit dem Leiter 1 können somit über Schalter (nicht dargestellt) weitere Leiter des Mittelspannungsnetzes verbunden sein.

Um eine Überprüfung zu ermöglichen, ob am Leiter 1 eine Spannung anliegt oder nicht, ist ein insgesamt mit dem Bezugszeichen 3 bezeichnetes kapazitives Spannungsprüfsystem (VDS) vorhanden, welches vorzugsweise entsprechend der Norm IEC 61243-5:1997 ausgebildet ist. Die am Leiter 1 anliegende Spannung kann im Bereich von 1kV bis 52kV liegen, wobei auch höhere Spannungen bis 69kV möglich sind (welche im Rahmen dieser Schrift immer noch als Mittelspannung bezeichnet werden).

Das kapazitive Spannungsprüfsystem 3 weist einen an den Leiter 1 angeschlossenen Koppelkondensator 4 auf. Die Kapazität des Koppelkondensators 4 ist an die Höhe der zur Anlage an den Leiter 1 vorgesehenen Spannung angepasst und kann beispielsweise im Bereich von 3 pF bis 250 pF liegen. Für Spannungen im Bereich von 30 kV bis 10 kV liegt die Kapazität beispielsweise insbesondere im Bereich von 5 pF bis 30 pF. Der Koppelkondensator 4 ist über den Leiter 5 einer Koaxialleitung mit einer Anschlussbuchse 7 verbunden, welche einen Messausgang des kapazitiven Spannungsprüfsystems darstellt. Der Schirm 6 der Koaxialleitung ist mit Erde verbunden. Die Kapazität der Koaxialleitung kann beispielsweise im Bereich von 50 pF bis 200 pF liegen und die Länge der Koaxialleitung im Bereich von ½ m bis 2 m. Größere Längen, insbesondere von bis zu 6 m sind möglich.

An die Anschlussbuchse 7 kann im Normalbetrieb eine Kontrollleuchte angeschlossen sein, von der angezeigt wird, ob der Leiter 1 unter Spannung steht.

Zwischen der Anschlussbuchse 7 und Erde kann ein (in den Figuren nicht dargestellter) Bürdewiderstand vorgesehen sein, um die Spannung an der Anschlussbuchse 7 zu begrenzen, wenn die Anschlussbuchse 7 offen ist.

Das Spannungsprüfsystem kann beispielsweise an einer Sammelschiene einer Schaltanlage angeschlossen sein, welche mit einem den Leiter 1 und den Kabelschirm 2 aufweisenden Mittelspannungskabel verbunden ist. Das Mittelspannungskabel weist in der Regel drei Leiter für die drei Phasen auf, die jeweils von einem Kabelschirm umgeben sind. Auch Mittelspannungskabel mit einem alle drei Leiter gemeinsam umgebenden Kabelschirm sind bekannt.

Das kapazitive Spannungsprüfsystem 3 kann hochohmig oder niederohmig (HR- oder LRM-System) ausgebildet sein.

Um eine Überprüfung des Mittelspannungsnetzes in einem gewissen Bereich um den Anschlusspunkt des Spannungsprüfsystems 3 an das Mittelspannungsnetz durchzuführen, wird eine Messung von Teilentladungen durchgeführt. Diese Messung erfolgt online, d.h. bei an dem Leiter 1 anliegender Spannung im Bereich von 1 kV bis 69 kV. Auch zur Vorbereitung der Messung muss der Leiter 1 nicht von der Mittelspannung freigeschalten werden.

Der Bereich um den Anschlusspunkt, über welchen erfindungsgemäß Teilentladungen gemessen werden können, kann vorteilhafterweise mehr als 1 km, insbesondere bis zu mehreren km betragen.

Hierzu wird eine elektrische Schaltungsanordnung 8 an die Anschlussbuchse 7 des Spannungsprüfsystems 3 angeschlossen, gegebenenfalls nach Entfernung der zuvor angeschlossenen Spannungsanzeige oder Kontrollleuchte. Diese elektrische Schaltungsanordnung 8 weist einen Frequenzgang-Anpassungswiderstand 9 auf, der einerseits an der Eingangsleitung 10, die an der Anschlussbuchse 7 angeschlossen ist, und andererseits an Erde angeschlossen ist. Der Widerstandswert des Frequenzgang-Anpassungswiderstands 9 beträgt vorzugsweise mehr als 25 kΩ und vorzugsweise weniger als 400 kΩ, wobei ein Bereich zwischen 50 kΩ und 200 kΩ bevorzugt ist.

Der Frequenzgang-Anpassungswiderstand 9 wird so gewählt, dass sich in Verbindung mit dem Spannungsprüfsystem 3 ein Hochpass mit einer Grenzfrequenz von weniger als 1 MHz, vorzugsweise weniger als 200 kHz ergibt. Die Grenzfrequenz des so ausgebildeten Hochpassfilters beträgt vorteilhafterweise mehr als 20 kHz, vorzugsweise mehr als 50 kHz. Eine beispielhafte Grenzfrequenz für den so ausgebildeten Hochpass liegt im Bereich von 100 kHz (+/- 30%).

Allerdings werden durch den vom Spannungsprüfsystem 3 in Verbindung mit dem Frequenzgang-Anpassungswiderstand 9 unterhalb der gewünschten Grenzfrequenz liegende Frequenzanteile nicht ausreichend ausgefiltert. Bei den zu messenden Teilentladungspulsen handelt es sich um Spannungspulse sehr geringer Größe, die von unterschiedlichen Störsignalen überlagert sind und somit nicht ohne Weiteres detektierbar sind. U.a. erfolgt eine Überlagerung durch den ausgekoppelten Anteil der am Leiter 1 anliegenden Mittelspannung mit der entsprechenden Frequenz dieser Mittelspannung (welche im Bereich von 16 2/3 Hz bis 60 Hz liegt). Es ist dem Frequenzgang-Anpassungswiderstand 9 daher ein Hochpassfilter 11 nachgeschaltet. Der Eingang des Hochpassfilters 11 ist hierbei mit der Eingangsleitung 10 verbunden. Die Grenzfrequenz des Hochpassfilters 11 entspricht vorteilhafterweise wenigstens größenordnungsmäßig (vorzugsweise im Bereich +/- 30%) der Grenzfrequenz des vom Spannungsprüfsystem 3 in Verbindung mit dem Frequenzgang-Anpassungswiderstand 9 gebildeten Hochpass.

Dem Hochpassfilter 11 ist im Weiteren ein Tiefpassfilter 12 nachgeschaltet. Von diesem werden oberhalb eines gewünschten Frequenzbandes liegende Frequenzanteile ausgefiltert, bei denen es sich ebenfalls zumindest weitgehend um Störanteile handelt. Die Grenzfrequenz des Tiefpassfilters 12 liegt vorzugsweise im Bereich von 5 MHz und 30 MHz, beispielsweise etwa im Bereich von 10 MHz (+/- 30%).

Der Tiefpassfilter 12 ist mit seinem Eingang somit an den Ausgang des Hochpassfilters 11 angeschlossen.

Auch eine umgekehrte Verbindung der Filter 11, 12 mit dem Frequenzgang-Anpassungswiderstand 9 ist denkbar und möglich, d.h. es könnte der Tiefpassfilter 12 an den Frequenzgang-Anpassungswiderstand 9 (also an die Eingangsleitung 10 der Schaltungsanordnung 8) angeschlossen sein und der Hochpassfilter 11 könnte an den Ausgang des Tiefpassfilters 12 angeschlossen sein.

Dem Hochpassfilter 11 und Tiefpassfilter 12 ist ein Verstärker 13 nachgeschaltet. Dem Verstärker 13 ist ein Impedanz-Anpassungswiderstand 14 nachgeschaltet. Der Eingang des Impedanz-Anpassungswiderstands 14 ist also an den Ausgang des Verstärkers 13 angeschlossen und der Ausgang des Impedanz-Anpassungswiderstands ist an die Ausgangsleitung 15 der Schaltungsanordnung 8 angeschlossen.

Der Verstärker 13 dient zur Anpassung an einen vorteilhaften Eingangspegel der an die Ausgangsleitung 15 der Schaltungsanordnung 8 angeschlossenen Messeinrichtung 16. Der Impedanz-Anpassungswiderstand 14 dient zur Anpassung des Ausgangswiderstands der Schaltungsanordnung 8 an den Eingangswiderstand der Messeinrichtung 16, sodass diese zumindest im Wesentlichen übereinstimmen (vorzugsweise im Bereich von +/- 20%).

Wesentliche Bestandteile der Messeinrichtung 16 sind ein Analog/Digitalwandler (=A/D-Wandler) 17 und eine Mikroprozessoreinheit 18. Der A/D-Wandler 17 dient zur Umwandlung eines an dessen Eingang anliegenden analogen Signals in ein digitales Signal. Dieses wird der Mikroprozessoreinheit 18 zugeführt und in dieser weiterverarbeitet.

An den Eingang der Messeinrichtung 16 schließt im Ausführungsbeispiel ein vorzugsweise als Blockkondensator ausgebildeter Kondensator 19 an, der insbesondere zur Entkopplung von gegebenenfalls am Eingang anliegenden Gleichspannungen dient.

An den Kondensator 19 kann ein Übertrager 20 anschließen, der insbesondere zur Potentialtrennung dient. Der Übertrager kann beispielsweise einen Widerstand von 50 Ω aufweisen.

An den Übertrager 20 schließt vorteilhafterweise eine DiodenSchutzschaltung 21 an, die insbesondere zur Limitierung der Höhe des Potentials dient. Der A/D-Wandler 17 ist im Ausführungsbeispiel an die Diodenschutzschaltung 21 angeschlossen.

Der Aufbau der Messeinrichtung 16 ist bekannt. Eine in dieser Weise ausgebildete Messeinrichtung kann an einen HFCT-Sensor angeschlossen werden, um Teilentladungen zu messen.

Von der Mikroprozessoreinheit ausgegebene Messsignale werden einer Ausgangsleitung zugeführt. An diese ist im Ausführungsbeispiel ein separater Computer 22 angeschlossen. In diesem erfolgt u.a. auch eine weitere Trennung der durch Teilentladungen hervorgerufenen Spannungspulse von Störspannungsanteilen. Insbesondere wird hierfür eine Impulsformerkennung durchgeführt.

Der Computer 22 dient auch zur Darstellung der Messergebnisse. Auch eine Kommunikationsschnittstelle mit einem Benutzer wird dem Computer 22 bereitgestellt.

Die Verbindung mit dem Computer 22 kann auch drahtlos über eine Funkverbindung oder über eine optische Leitung erfolgen.

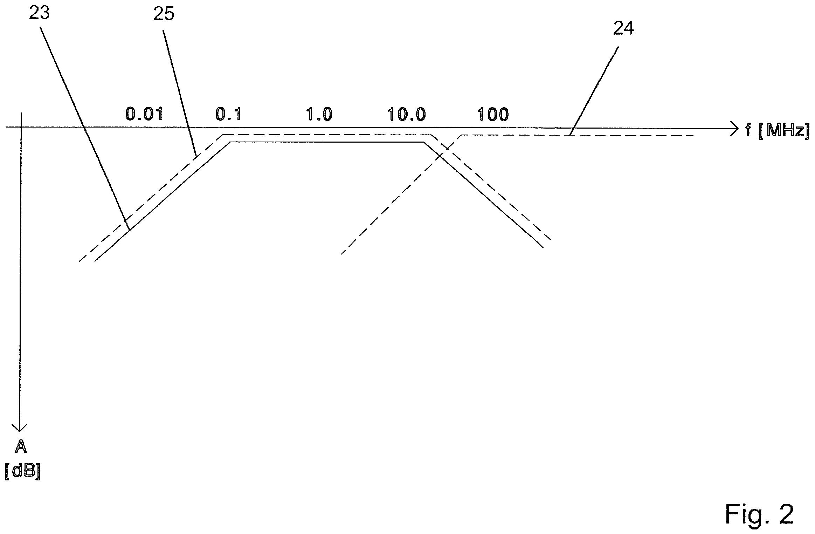

Der vom Spannungsprüfsystem 3 in Verbindung mit der elektrischen Schaltungsanordnung 8 insgesamt ausgebildete Frequenzgang ist in Fig. 2 als durchgezogene Linie 23 dargestellt. Es ist die Abschwächung (Attenuation) A in dB gegen die Frequenz f in MHz aufgetragen. Es wird somit ein Bandpass ausgebildet, dessen Grenzfrequenzen im Ausführungsbeispiel bei 100 kHz und 10-20 MHz liegen.

Im Vergleich dazu ist durch die gestrichelte Linie 24 der Frequenzgang dargestellt, wie er sich allein durch das Spannungsprüfsystem 3 in Verbindung mit der Messeinrichtung 16 ergeben würde. Im Weiteren ist mit der gestrichelten Linie 25 als Vergleich der Frequenzgang dargestellt, wie er sich bei Einsatz der Messeinrichtung 16 in Verbindung mit einem herkömmlichen HFCT-Sensor ergibt. Durch die Schaltungsanordnung 8 wird also in Verbindung mit dem kapazitiven Spannungsprüfsystem 3 der Frequenzgang eines herkömmlichen HFCT-Sensors imitiert.

In Fig. 1 ist mit dem Leiter 1 lediglich eine Phase eines Mittelspannungskabels dargestellt, an die das Spannungsprüfsystem 3 angeschlossen ist. In analoger Weise können Spannungsprüfsysteme auch an die anderen Phasen eines Mittelspannungskabels (nicht dargestellt) angeschlossen sein, an deren Anschlussbuchsen jeweils in analoger Weise unter Zwischenschaltung einer Schaltungsanordnung 8 eine Messung von Teilentladungen mittels einer Messeinrichtung 16 durchgeführt wird.

Eine Schaltungsanordnung 8 und/oder Messeinrichtung 16 kann auch zur gleichzeitigen Messung aller Phasen ausgebildet sein.

Der Frequenzgang-Anpassungswiderstand 9 ist bevorzugt wie dargestellt ein ohmscher Widerstand. Denkbar und möglich wäre es auch, einen solchen Widerstand durch Schaltungselemente zu realisieren, die einen ohmschen Widerstand nachbilden, z.B. durch einen Feldeffekttransistor mit entsprechend angesteuertem Kanalwiderstand. Beispielsweise kann ein ohmscher Widerstand auch mit Operationsverstärkern nachgebildet werden.

Analoges gilt grundsätzlich auch für den Impedanz-Anpassungswiderstand 14.

Ein Tiefpassfilter 12 könnte auch dadurch realisiert werden, dass nach der A/D-Wandlung eine entsprechende Signalverarbeitung des digitalen Signals durchgeführt wird.

Vorzugsweise ist am Eingang der Schaltungsanordnung eine in Fig. 1 nicht dargestellte Schutzschaltung vorgesehen, um die nachfolgenden Bauteile vor Spannungsspitzen zu schützen. Solche Schutzschaltungen zum Abfangen von Spannungsspitzen sind bekannt. Insbesondere dienen hierzu Halbleiterbauelemente, z.B. Varistoren, Dioden oder Gasableiter.

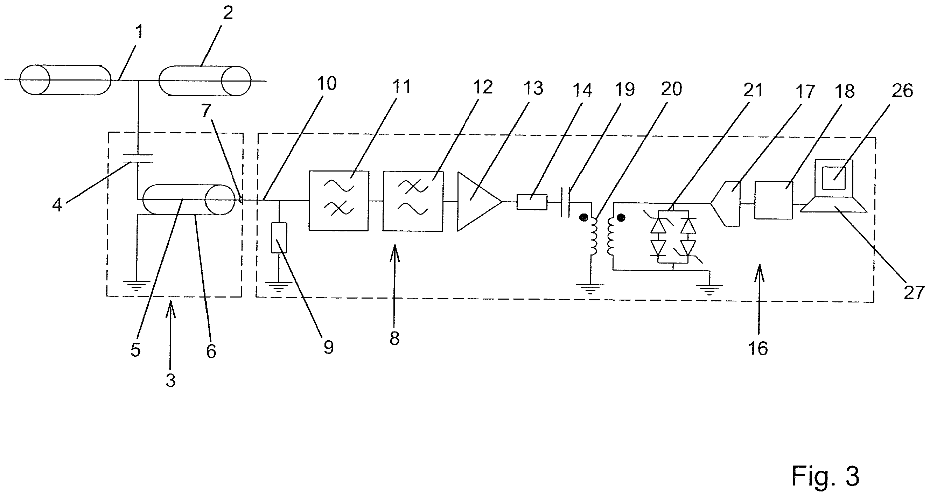

In Fig. 3 ist ein zweites Ausführungsbeispiel der Erfindung dargestellt. Im Folgenden werden Unterschiede gegenüber dem ersten Ausführungsbeispiel erläutert. Im Übrigen sind die Ausführungen zum ersten Ausführungsbeispiel in analoger Weise heranziehbar.

Beim Ausführungsbeispiel von Fig. 3 sind die Schaltungsanordnung 8 und die Messeinrichtung 16 in einem gemeinsamen Gehäuse untergebracht, welches durch eine gestrichelte Linie angedeutet ist. Die Komponenten der Schaltanordnung 8 und Messeinrichtung 16 entsprechen denjenigen, wie sie im ersten Ausführungsbeispiel beschrieben sind. Es wird also eine in einem einzigen Gehäuse untergebrachte Messanordnung umfassend die Schaltungsanordnung 8 und die Messeinrichtung 3 ausgebildet, welche an die Anschlussbuchse 7 des kapazitiven Spannungsprüfsystems 3 angeschlossen wird.

Im zweiten Ausführungsbeispiel ist im Weiteren die Funktionalität des im ersten Ausführungsbeispiel angeschlossenen Computers 22 direkt in diese Messanordnung integriert. Die Messanordnung weist somit einen Bildschirm 26 und eine Ein/Ausgabeeinrichtung 27, insbesondere umfassend eine Tastatur und/oder Maus auf, welche an die Mikroprozessoreinheit 18 angeschlossen sind. Es kann eine Anordnung im gleichen Gehäuse vorgesehen sein oder der Bildschirm 26 und/oder die Ein/Ausgabeeinrichtung 27 weist ein eigenes Gehäuse auf. In die Mikroprozessoreinheit 18 ist auch ein entsprechender beschreibbarer Speicher integriert.

Andererseits könnte im zweiten Ausführungsbeispiel analog wie beim ersten Ausführungsbeispiel auch ein separater Computer 22 an die Messanordnung, also an den Ausgang der Messeinrichtung 16 angeschlossen sein.

Umgekehrt könnte im ersten Ausführungsbeispiel die Funktionalität des Computers 22 oder ein Teil hiervon direkt in die Messeinrichtung 16 integriert sein, analog wie beim zweiten Ausführungsbeispiel.

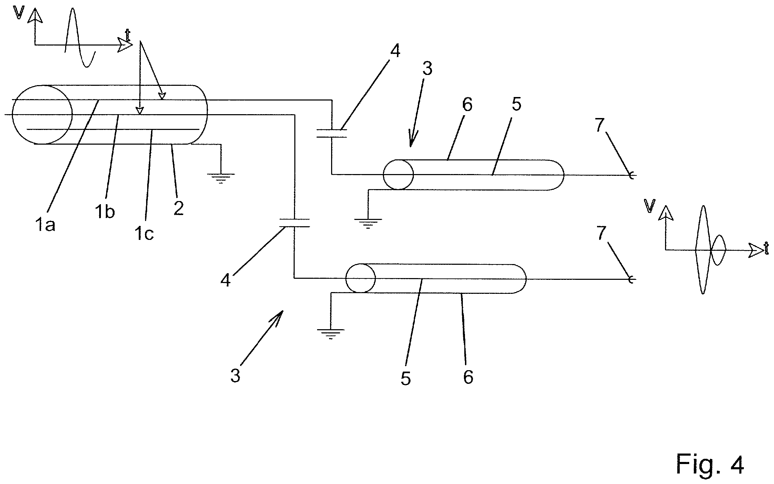

Ein drittes Ausführungsbeispiel der Erfindung wird im Folgenden anhand von Fig. 4 erläutert. Im Folgenden werden insbesondere die Unterschiede zu den zuvor beschriebenen Ausführungsbeispielen erläutert. Im Übrigen können die Beschreibungen zu den vorhergehenden Ausführungsbeispielen analog herangezogen werden.

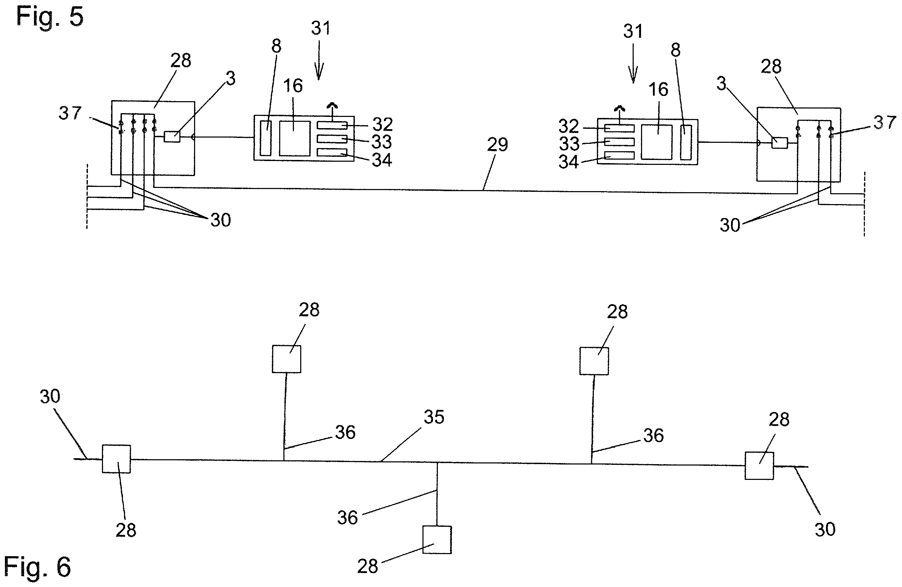

Dieses Ausführungsbeispiel dient insbesondere zur Messung von Teilentladungen bei Mittelspannungskabeln, bei denen die Leiter 1a, 1b, 1c aller drei Phasen von einem gemeinsamen Kabelschirm 2 umgeben sind. Bei solchen Kabeln kann es nicht nur zu Teilentladungen zwischen einer der Phase und dem Kabelschirm sondern auch zu Teilentladungen zwischen zwei Phasen kommen. Es sind wiederum alle drei Phasen mit einem jeweiligen Spannungsprüfsystem 3 versehen. In Fig. 4 sind nur für zwei der Phasen die Spannungsprüfsysteme 3 eingezeichnet. An den Ausgängen von zwei der Spannungsprüfsysteme ist eine Schaltungsanordnung 8 (nicht dargestellt in Fig. 5) angeschlossen. Die Schaltungsanordnung ist hier derart modifiziert, dass diese zwei Eingänge aufweist. Es wird in der Folge die Differenz dieser beiden Phasen gebildet. Wenn Teilentladungen zwischen diesen beiden Phasen auftreten, so sind die daraus resultierenden Spannungspulse an den Ausgängen der beiden zugeordneten Spannungsprüfsysteme 3 von inverser Polarität. Durch die Differenzbildung wird somit eine doppelte Höhe des Spannungspulses einer jeweiligen Teilentladung ausgebildet, während Störsignale, welche auf beide Phasen die gleichen oder ähnliche Auswirkungen haben, eliminiert bzw. verringert werden.

Es können gleichzeitig drei solche Differenzmessungen durchgeführt werden, um die Teilentladungen zwischen jeweils zwei der drei Leitungen 1a, 1b, 1c zu ermitteln.

Die Differenzbildung könnte statt in der Schaltungsanordnung 8 auch in der Messeinrichtung 16 durchgeführt werden. An die beiden Ausgänge der Spannungsprüfsysteme 3 würden somit zwei Schaltungsanordnungen 8 angeschlossen werden. Die Messeinrichtung 16 würde dann zwei Eingänge aufweisen, die an die Ausgänge der beiden Schaltungsanordnungen 8 angeschlossen würden.

Die Schaltungsanordnung könnte auch drei Eingänge für alle drei Phasen aufweisen, wobei die Auswahl von zwei der drei Phasen zur Differenzbildung durch entsprechende Schalter, auch elektronische Schalter, durchgeführt werden könnte. Bei Durchführung der Differenzbildung in der Messeinrichtung könnte diese drei Eingänge aufweisen.

Eine Messanordnung gemäß der Erfindung weist im Weiteren vorteilhafterweise eine Zeiterfassungseinheit zur Erfassung der zeitlichen Differenz zwischen von der Messanordnung erfassten Spannungspulsen auf. Es kann dadurch der Ort einer Teilentladung im Kabel ermittelt werden. Hierzu wird die Messanordnung an einem Kabelende an einen Messausgang, der beispielsweise als Anschlussbuchse ausgebildet ist, eines kapazitiven Spannungsprüfsystems einer Schaltanlage angeschlossen und es wird der zeitliche Abstand zwischen dem direkt von der Stelle der Teilentladung zur Messanordnung laufenden Spannungspuls und dem von der Stelle der Teilentladung zum entfernten Kabelende laufenden und an diesem entfernten Kabelende zurückreflektierten Spannungspuls erfasst. Aus diesem zeitlichen Abstand und der bekannten Ausbreitungsgeschwindigkeit des Spannungspulses kann von einer Auswerteinheit der Messanordnung der Ort der Teilentladung ermittelt werden. Es können hierbei statistische Methoden eingesetzt werden, bei denen eine Mehrzahl von solchen Ereignissen ausgewertet werden.

Beispielsweise, um den Ort der Teilentladung auch bei sehr langen Kabeln zu ermitteln (wenn der am entfernten Kabelende reflektierte Teilentladungspuls nicht oder nicht zuverlässig detektierbar ist), ist der Einsatz von erfindungsgemäßen Messanordnungen in einem Messsystem zur Lokalisierung des Ortes einer Teilentladung (in einem Stromnetz mit einer im Bereich von 1kV bis 69kV liegenden Betriebsspannung) schematisch in Fig. 5 dargestellt. Dargestellt sind eine erste und eine zweite Schaltanlage 28, an denen ein spannungsführendes Kabel 29 endet. Eine jeweilige der Schaltanlagen 28 weist für das Kabel 29 ein kapazitives Spannungsprüfsystem 3 auf, welche jeweils vorgesehen sind, um zu prüfen, ob das Kabel 29 spannungsführend ist. Die kapazitiven Spannungsprüfsysteme 3 können in herkömmlicher Weise ausgebildet sein, insbesondere analog wie im Zusammenhang mit den Fig. 1 und 3 beschrieben. Vorzugsweise sind die kapazitiven Spannungsprüfsysteme 3 entsprechen der Norm IEC 61243-5:1997 ausgebildet.

Weitere Kabel 30, die an einer jeweiligen der Schaltanlagen 28 enden, sind in Fig. 5 angedeutet. Ebenso sind Schalter 37 angedeutet.

Die kapazitiven Spannungsprüfsysteme 3 mit ihrem jeweiligen Messausgang sind somit an den beiden Enden des Kabels 29 angeordnet. An den Messausgang eines jeweiligen der kapazitiven Spannungsprüfsysteme ist eine Messanordnung 31 angeschlossen, welche eine Schaltungsanordnung 8, die entsprechend der anhand der Fig. 1 oder 3 beschriebenen Schaltungsanordnung ausgebildet ist, und eine Messeinrichtung 16 umfasst, die entsprechend der anhand der Fig. 1 oder 3 beschriebenen Messeinrichtung ausgebildet ist.

Eine jeweilige Messanordnung 31 weist zusätzlich eine Zeiterfassungseinheit 32 auf. Die Zeiterfassungseinheiten 32 der beiden Messanordnungen 31 sind hierbei mittels einer gemeinsamen Zeitbasis miteinander synchronisiert. Eine solche gemeinsame Zeitbasis kann beispielsweise durch einen GPS-Zeitstempel bereitgestellt werden. Es ist hierzu an einer jeweiligen Zeiterfassungseinheit 32 eine Antenne angedeutet, welche ebenfalls angedeutete GPS-Signale empfängt. Eine Zeitsynchronisation mittels GPS ist bekannt.

Mittels der Zeiterfassungseinheiten 32 wird die jeweilige Zeit ermittelt, zu welcher ein jeweiliger Teilentladungspuls (=Spannungspuls aufgrund einer Teilentladung) detektiert wird. Durch Vergleich der Zeiten, zu welchen die durch die Teilentladungen bewirkten Spannungspulse detektiert werden, können die Differenzen der Laufzeiten dieser Spannungspulse zu den beiden Messanordnungen 31 ermittelt werden.

Um eine Kommunikation zwischen den beiden Messanordnungen 31 zu ermöglichen, weisen die Messanordnungen 31 im Weiteren Kommunikationseinheiten 33 auf. Es kann mittels dieser Kommunikationseinheiten 33 vorzugsweise eine drahtlose Kommunikation zwischen den beiden Messanordnungen 31 bereitgestellt werden, beispielsweise über das Mobilfunknetz. Eine drahtgebundene Kommunikation (Glasfaserleitungen, Internet, Intranet) ist auch denkbar und möglich.

Mindestens eine der Messanordnungen 31 weist zudem eine Auswerteinheit 34 auf, von welcher eine Auswertung der von den beiden Messanordnungen 31 aufgenommenen Messwerte durchgeführt wird. Im Ausführungsbeispiel sind die Messanordnungen 31 gleich ausgebildet, sodass jede der Messanordnungen 31 eine Auswerteinheit aufweist, wobei die Auswertung von einer der Messanordnungen 31 durchgeführt wird, welche als "Master" betrieben wird. Die andere der Messanordnungen 31 wird damit als "Slave" betrieben, wobei auch mehr als eine solche weitere Messanordnung vorhanden sein kann, wie weiter unten ausgeführt.

Die Auswerteinheit 34 ermittelt aus der Differenz der Laufzeiten eines von einer Teilentladung hervorgerufenen Spannungspulses zu den beiden Messanordnungen 31, der Länge des Kabels 29 und der bekannten Ausbreitungsgeschwindigkeit der Spannungspulse einen Abstand des Ortes der Teilentladung vom betreffenden Kabelende. Damit kann die Stelle des Kabels 29, an welchem die Teilentladung aufgetreten ist, lokalisiert werden. Bei der Auswertung wird hierbei bevorzugt eine Mehrzahl von Messungen einbezogen.

Bei der Auswerteinheit 34 könnte es sich grundsätzlich auch um ein separates Gerät handeln, welches mit den Messanordnungen 31 kommuniziert oder dem die bei den Messungen erhaltenen Messwerte nach den Messungen zugeführt werden.

Die Erfindung ist auch bei sogenannten T-verzweigten Kabeln einsetzbar. Ein solches ist in Fig. 6 beispielhaft schematisch dargestellt. Von einem Hauptstrang 35 führen Abzweigungsstränge 36 ab. An den Enden des Hauptstrangs 35 sowie an den Enden der Abzweigungsstränge 36 ist jeweils eine Schaltanlage 28 angeordnet. Die Schaltanlagen 28 weisen jeweils ein kapazitives Spannungsprüfsystem für das Kabel auf (nicht dargestellt in Fig. 6). Wenn zusätzlich zur Anordnung von Messanordnungen analog Fig. 5 an den beiden Enden des Hauptstrangs auch solche Messanordnungen an dem Ende von einem, von mehreren oder von allen Abzweigungssträngen 36 vorgesehen werden, wobei alle Messanordnungen zeitsynchronisiert sind, so kann die Lokalisierung des Ortes der Teilentladung im T-verzweigten Kabel verbessert werden. Auch eine Lokalisierung im Bereich von Abzweigungssträngen 36 wird in diesem Fall dadurch ermöglicht.

Eine Zeitsynchronisierung zwischen zwei oder mehreren Messanordnungen 31 kann auch in anderer Weise als GPS-basiert erfolgen, beispielsweise über eine optische Glasfiber-Übertragung. Bei einer ausreichend hohen Ganggenauigkeit der Zeiterfassungseinheiten wäre es auch denkbar und möglich, die Messanordnungen 31 zunächst an einem gemeinsamen Ort zu synchronisieren und dann erst zu den jeweiligen Einsatzorten zu bringen.

Bei den Messanordnungen 31 handelt es sich jeweils um Mikroprozessorsysteme. Die Zeiterfassungseinheit, Kommunikationseinheit und Auswerteinheit sind als Funktionseinheiten innerhalb eines solchen Mikroprozessorsystems zu verstehen und werden sich im Allgemeinen physikalische Bauteile, beispielsweise einen Mikroprozessor, Speicherbausteine, usw. teilen.

Es kann vorteilhafterweise vorgesehen sein, dass eine jeweilige der Messanordnungen gemäß Fig. 5 auch zum einzelnen Einsatz an einem kapazitiven Spannungsprüfsystem an einem Kabelende ausgebildet ist, um aus dem zeitlichen Abstand zwischen dem direkt zu diesem Kabelende laufenden Teilentladungspuls und dem am entfernten Kabelende reflektierten Teilentladungspuls den Ort der Teilentladung zu ermitteln, wie bereits beschrieben wurde. Mittels der Zeiterfassungseinheit 32 kann dann dieser zeitliche Abstand ermittelt werden und von der Auswerteinheit 34 ausgewertet werden.

Ein kapazitives Spannungsprüfsystem kann auf unterschiedliche Arten an den Leiter des Kabels des Stromnetzes gekoppelt sein. Beispielsweise kann der Koppelkondensator eines solchen kapazitives Spannungsprüfsystems auch in einem Isolierstützer oder einem Kabelstecker untergebracht sein oder auch separat montiert sein. Obwohl es in vielen Situationen vorteilhaft ist, dass als Messausgang des kapazitiven Spannungsprüfsystems eine Anschlussbuchse vorgesehen ist, ist dies nicht zwingend erforderlich. So könnte der Messausgang des kapazitiven Spannungsprüfsystems auch direkt mit der erfindungsgemäßen Schaltungsanordnung verdrahtet sein.

**Legende**

| | | | |
|---|---|---|---|
| Zu den Hinweisziffern | | | |
| 1 | Leiter | 25 | Linie |
| 1a | Leiter | 26 | Bildschirm |
| 1b | Leiter | 27 | Ein/Ausgabeeinrichtung |
| 1c | Leiter | 28 | Schaltanlage |
| 2 | Kabelschirm | 29 | Kabel |
| 3 | Spannungsprüfsystem | 30 | Kabel |
| 4 | Koppelkondensator | 31 | Messanordnung |
| 5 | Leiter | 32 | Zeiterfassungseinheit |
| 6 | Schirm | 33 | Kommunikationseinheit |
| 7 | Anschlussbuchse | 34 | Auswerteinheit |
| 8 | Schaltungsanordnung | 35 | Hauptstrang |
| 9 | Frequenzgang-Anpassungswiderstand | 36 | Abzweigungsstrang |
| | | 37 | Schalter |
| 10 | Eingangsleitung | | |
| 11 | Hochpassfilter | | |
| 12 | Tiefpassfilter | | |
| 13 | Verstärker | | |
| 14 | Impedanz-Anpassungswiderstand | | |
| 15 | Ausgangsleitung | | |
| 16 | Messeinrichtung | | |
| 17 | Analog/Digital-Wandler | | |
| 18 | Mikroprozessoreinheit | | |
| 19 | Kondensator | | |
| 20 | Übertrager | | |
| 21 | Diodenschutzschaltung | | |
| 22 | Computer | | |
| 23 | Linie | | |
| 24 | Linie | | |

## Patentansprüche

1. Elektrische Schaltungsanordnung konfiguriert zum Verbinden einer
elektrischen Messeinrichtung (16), welche zur Messung von Teilentladungen in einem Stromnetz mit einer im Bereich von 1kV bis 69kV liegenden Betriebsspannung dient und einen A/D-Wandler (17) zur Umwandlung eines gemessenen Spannungsimpulses in ein digitales Signal und eine Mikroprozessoreinheit (18) zur Auswertung des digitalen Signals aufweist, mit einem Messausgang eines kapazitiven Spannungsprüfsystems (3) einer Schaltanlage für das Stromnetz mit der im Bereich von 1kV bis 69kV liegenden Betriebsspannung, wobei
die
elektrische Schaltungsanordnung (8) einen Frequenzgang-Anpassungswiderstand (9), der zwischen einer Eingangsleitung (10) zur Verbindung mit dem spannungsführenden Pol des Messausgangs und Erde geschaltet ist, und einen dem Frequenzgang-Anpassungswiderstand (9) nachgeschalteten Hochpassfilter (11) aufweist.

2. Elektrische Schaltungsanordnung nach Anspruch 1, **dadurch gekennzeichnet, dass** der Messausgang des kapazitiven Spannungsprüfsystems (3) als Anschlussbuchse (7) ausgebildet ist.

3. Elektrische Schaltungsanordnung nach Anspruch 1 oder 2, **dadurch gekennzeichnet, dass** der Frequenzgang-Anpassungswiderstand (9) mehr als 25 kΩ beträgt, wobei der Frequenzgang-Anpassungswiderstand (9) vorzugsweise weniger als 400 kΩ beträgt.

4. Elektrische Schaltungsanordnung nach Anspruch 3, **dadurch gekennzeichnet, dass** der Frequenzgang-Anpassungswiderstand (9) im Bereich von 50 kΩ bis 200 kΩ liegt.

5. Elektrische Schaltungsanordnung nach einem der Ansprüche 1 bis 4, **dadurch gekennzeichnet, dass** die Grenzfrequenz des Hochpassfilters (11) im Bereich von 50 kHz und 200 kHz liegt.

6. Elektrische Schaltungsanordnung nach einem der Ansprüche 1 bis 5, **dadurch gekennzeichnet, dass** dem Frequenzgang-Anpassungswiderstand (9) ein Tiefpassfilter (12) nachgeschaltet ist, dessen Grenzfrequenz vorzugsweise im Bereich zwischen 5 MHz und 20 MHz liegt.

7. Elektrische Schaltungsanordnung nach Anspruch 6, **dadurch gekennzeichnet, dass** dem Hochpassfilter (11) und Tiefpassfilter (12) ein Verstärker (13) nachgeschaltet ist.

8. Elektrische Schaltungsanordnung nach Anspruch 7, **dadurch gekennzeichnet, dass** dem Verstärker (13) ein Impedanz-Anpassungswiderstand (14) zur Anpassung an den Eingangswiderstand der Messeinrichtung (16) nachgeschaltet ist, der vorzugsweise weniger als 100 Ω beträgt.

9. Messanordnung zur Messung von Teilentladungen an einem Messausgang eines kapazitiven Spannungsprüfsystems einer Schaltanlage für ein Stromnetz mit einer im Bereich von 1kV bis 69kV liegenden Betriebsspannung, wobei die Messanordnung einen A/D-Wandler (17) zur Umwandlung eines gemessenen Spannungsimpulses in ein digitales Signal und eine Mikroprozessoreinheit (18) zur Auswertung des digitalen Signals aufweist, **dadurch gekennzeichnet, dass** die Messanordnung eine dem A/D-Wandler (17) vorgeschaltete elektrische Schaltungsanordnung (8) nach einem der Ansprüche 1 bis 8 aufweist.

10. Messanordnung nach Anspruch 9, **dadurch gekennzeichnet, dass** der Messausgang des kapazitiven Spannungsprüfsystems (3) als Anschlussbuchse (7) ausgebildet ist.

11. Messanordnung nach Anspruch 9 oder 10, **dadurch gekennzeichnet, dass** zur Messung von Teilentladungen zwischen zwei Leitern (1a, 1b, 1c) eines mehrpoligen Kabels für Spannungen im Bereich von 1kV bis 69kV die durch die Teilentladungsmessungen an den beiden Leitern (1a, 1b, 1c) erhaltenen Messsignale voneinander subtrahiert werden.

12. Messanordnung nach einem der Ansprüche 9 bis 11, **dadurch gekennzeichnet, dass** die Messanordnung zur Lokalisierung des Ortes einer Teilentladung eine Zeiterfassungseinheit zur Erfassung der zeitlichen Differenz zwischen von der Messanordnung erfassten Spannungspulsen aufweist.

13. Messsystem zur Lokalisierung des Ortes einer Teilentladung in einem Stromnetz mit einer im Bereich von 1kV bis 69kV liegenden Betriebsspannung, **dadurch gekennzeichnet, dass** das Messsystem mindestens zwei Messanordnungen (31) nach einem der Ansprüche 9 bis 12 zur Messung von Teilentladungen an einem jeweiligen Messausgang von an einem jeweiligen Ende eines Kabels (29) des Stromnetzes angeordneten kapazitiven Spannungsprüfsystemen (3) aufweist und dass die Messanordnungen (31) miteinander synchronisierbare Zeiterfassungseinheiten (32) zur Erfassung einer Differenz der Laufzeiten eines von einer Teilentladung hervorgerufenen Spannungspulses zur jeweiligen Messanordnung (31) aufweisen.

14. Messsystem nach Anspruch 13, **dadurch gekennzeichnet, dass** das Messsystem mindestens eine Auswerteinheit (34) zur Auswertung der erfassten Differenz der Laufzeiten des von einer Teilentladung hervorgerufenen Spannungspulses zur Bestimmung eines Ortes der Teilentladung aufweist, wobei vorzugsweise mindestens eine der Messanordnungen (31) eine derartige Auswerteinheit (34) aufweist.

15. Messsystem nach einem der Ansprüche 12 bis 14, **dadurch gekennzeichnet, dass** die Messanordnungen (31) Kommunikationseinheiten (33) zum gegenseitigen, vorzugsweise drahtlosen, Datenaustausch aufweist.

## Claims

1. Electrical circuit arrangement, configured to connect an electrical measuring device (16), which is used to measure partial discharges in a power grid having an operating voltage in the range from 1 kV to 69 kV, and which comprises an A/D converter (17) for converting a measured voltage pulse into a digital signal and a microprocessor unit (18) for evaluating the digital signal, to a measurement output of a capacitive voltage testing system (3) of a power switching station for the power grid having the operating voltage in the range from 1 kV to 69 kV, wherein the electrical circuit arrangement (8) comprises a frequency response matching resistor (9), which is connected between ground and an input line (10) for connection to the live pole of the measurement output, and a high-pass filter (11) connected downstream of the frequency response matching resistor (9).

2. Electrical circuit arrangement according to claim 1, **characterized in that** the measurement output of the capacitive voltage testing system (3) is in the form of a connection socket (7).

3. Electrical circuit arrangement according to claim 1 or 2, **characterized in that** the rating of the frequency response matching resistor (9) is greater than 25 kΩ, the rating of the frequency response matching resistor (9) preferably being lower than 400 kΩ.

4. Electrical circuit arrangement according to claim 3, **characterized in that** the rating of the frequency response matching resistor (9) is in the range from 50 kΩ to 200 kΩ.

5. Electrical circuit arrangement according to any of claims 1 to 4, **characterized in that** the cut-off frequency of the high-pass filter (11) is in the range from 50 kHz and 200 kHz.

6. Electrical circuit arrangement according to any of claims 1 to 5, **characterized in that** a low-pass filter (12), the cut-off frequency of which is preferably in the range between 5 MHz and 20 MHz, is connected downstream of the frequency response matching resistor (9).

7. Electrical circuit arrangement according to claim 6, **characterized in that** an amplifier (13) is connected downstream of the high-pass filter (11) and the low-pass filter (12).

8. Electrical circuit arrangement according to claim 7, **characterized in that** an impedance matching resistor (14) for matching to the input resistor of the measuring device (16), the rating of which is preferably lower than 100 Ω, is connected downstream of the amplifier (13).

9. Measuring assembly for measuring partial discharges at a measurement output of a capacitive voltage testing system of a power switching station for a power grid having an operating voltage in the range from 1 kV to 69 kV, the measuring assembly comprising an A/D converter (17) for converting a measured voltage pulse into a digital signal and a microprocessor unit (18) for evaluating the digital signal, **characterized in that** the measuring assembly comprises an electrical circuit arrangement (8) according to any of claims 1 to 8 connected upstream of the A/D converter (17).

10. Measuring assembly according to claim 9, **characterized in that** the measurement output of the capacitive voltage testing system (3) is in the form of a connection socket (7).

11. Measuring assembly according to claim 9 or 10, **characterized in that**, in order to measure partial discharges between two conductors (1a, 1b, 1c) of a multi-pole cable for voltages in the range from 1 kV to 69 kV, the measurement signals obtained by way of the partial discharge measurements on the two conductors (1a, 1b, 1c) are subtracted from each other.

12. Measuring assembly according to any of claims 9 to 11, **characterized in that**, in order to pinpoint the location of a partial discharge, the measuring assembly comprises a time detection unit for detecting the time difference between voltage pulses detected by the measuring assembly.

13. Measuring system for pinpointing the location of a partial discharge in a power grid having an operating voltage in the range from 1 kV to 69 kV, **characterized in that** the measuring system comprises at least two measuring assemblies (31) according to any of claims 9 to 12 for measuring partial discharges at a respective measurement output of capacitive voltage testing systems (3) arranged at a respective end of a cable (29) of the power grid, and **in that** the measuring assemblies (31) comprise time detection units (32), capable of being synchronized with each other, for detecting a difference in the transit times of a voltage pulse, generated by a partial discharge, to the respective measuring assembly (31).

14. Measuring system according to claim 13, **characterized in that** the measuring system comprises at least one evaluation unit (34) for evaluating the detected difference in the transit times of the voltage pulse, generated by a partial discharge, in order to determine a location of the partial discharge, wherein preferably at least one of the measuring assemblies (31) comprises such an evaluation unit (34).

15. Measuring system according to any of claims 12 to 14, **characterized in that** the measuring assemblies (31) comprise communication units (33) for exchanging data with each other, preferably wirelessly.

## Revendications

1. Circuit électrique configuré pour relier un dispositif de mesure électrique (16) qui sert à mesurer des décharges partielles dans un réseau électrique ayant une tension de service située dans la plage allant de 1 kV à 69 kV et qui est muni d'un convertisseur A/N (17) pour convertir une impulsion de tension mesurée en un signal numérique et d'une unité de microprocesseur (18) pour évaluer le signal numérique, avec une sortie de mesure d'un système de contrôle de tension capacitif (3) d'un appareillage électrique pour le réseau électrique ayant la tension de service située dans la plage allant de 1 kV à 69 kV, le circuit électrique (8) étant muni d'une résistance d'adaptation de la réponse en fréquence (9) qui est connectée entre une ligne d'entrée (10) pour la liaison avec le pôle sous tension de la sortie de mesure et la terre, et d'un filtre passe-haut (11) connecté en aval de la résistance d'adaptation de la réponse en fréquence (9).

2. Circuit électrique selon la revendication 1, **caractérisé en ce que** la sortie de mesure du système de contrôle de tension capacitif (3) est conçue comme une douille de raccordement (7).

3. Circuit électrique selon la revendication 1 ou 2, **caractérisé en ce que** la résistance d'adaptation de la réponse en fréquence (9) est supérieure à 25 kΩ, la résistance d'adaptation de la réponse en fréquence (9) étant de préférence inférieure à 400 kΩ.

4. Circuit électrique selon la revendication 3, **caractérisé en ce que** la résistance d'adaptation de la réponse en fréquence (9) est comprise dans la plage allant de 50 kΩ à 200 kΩ.

5. Circuit électrique selon l'une des revendications 1 à 4, **caractérisé en ce que** la fréquence de coupure du filtre passe-haut (11) est comprise dans la plage allant de 50 kHz à 200 kHz.

6. Circuit électrique selon l'une des revendications 1 à 5, **caractérisé en ce qu'**un filtre passe-bas (12), dont la fréquence de coupure se situe de préférence dans la plage allant de 5 MHz à 20 MHz, est connecté en aval de la résistance d'adaptation de la réponse en fréquence (9).

7. Circuit électrique selon la revendication 6, **caractérisé en ce qu'**un amplificateur (13) est connecté en aval du filtre passe-haut (11) et du filtre passe-bas (12).

8. Circuit électrique selon la revendication 7, **caractérisé en ce qu'**une résistance d'adaptation d'impédance (14) pour l'adaptation à la résistance d'entrée du dispositif de mesure (16) et qui est de préférence inférieure à 100 Ω est connectée en aval de l'amplificateur (13).

9. Dispositif de mesure pour la mesure de décharges partielles sur une sortie de mesure d'un système de contrôle de tension capacitif d'un appareillage électrique pour un réseau électrique ayant une tension de service située dans la plage allant de 1 kV à 69 kV, le dispositif de mesure étant munie d'un convertisseur A/N (17) pour convertir une impulsion de tension mesurée en un signal numérique et d'une unité de microprocesseur (18) pour évaluer le signal numérique, **caractérisé en ce que** le dispositif de mesure comporte un circuit électrique (8) selon l'une des revendications 1 à 8 raccordé en amont du convertisseur A/N (17).

10. Dispositif de mesure selon la revendication 9, **caractérisé en ce que** la sortie de mesure du système de contrôle de tension capacitif (3) est conçue sous la forme d'une douille de raccordement (7).

11. Dispositif de mesure selon la revendication 9 ou 10, **caractérisé en ce que** pour mesurer des décharges partielles entre deux conducteurs (1a, 1b, 1c) d'un câble multipolaire pour des tensions comprises entre 1 kV et 69 kV, les signaux de mesure obtenus par les mesures de décharges partielles sur les deux conducteurs (1a, 1b, 1c) sont soustraits les uns des autres.

12. Dispositif de mesure selon l'une des revendications 9 à 11, **caractérisé en ce que,** pour localiser l'emplacement d'une décharge partielle, le dispositif de mesure est muni d'une unité d'acquisition de temps pour détecter la différence de temps entre les impulsions de tension détectées par le dispositif de mesure.

13. Système de mesure pour la localisation de l'emplacement d'une décharge partielle dans un réseau électrique ayant une tension de service située dans la plage allant de 1 kV à 69 kV, **caractérisé en ce que** le système de mesure est muni d'au moins deux dispositifs de mesure (31) selon l'une des revendications 9 à 12 pour mesurer des décharges partielles à une sortie de mesure respective de systèmes de contrôle de tension capacitifs (3) disposés à une extrémité respective d'un câble (29) du réseau électrique, et **en ce que** les dispositifs de mesure (31) sont munis d'unités d'acquisition de temps (32) synchronisables entre elles pour détecter une différence des temps de parcours d'une impulsion de tension provoquée par une décharge partielle par rapport au dispositif de mesure (31) respectif.

14. Système de mesure selon la revendication 13, **caractérisé en ce que** le système de mesure est muni d'au moins une unité d'évaluation (34) pour évaluer la différence détectée des temps de parcours de l'impulsion de tension provoquée par une décharge partielle afin de déterminer un emplacement de la décharge partielle, de préférence au moins l'un des dispositifs de mesure (31) étant muni d'une telle unité d'évaluation (34).

15. Système de mesure selon l'une des revendications 12 à 14, **caractérisé en ce que** les dispositifs de mesure (31) sont munis d'unités de communication (33) pour l'échange mutuel de données, de préférence sans fil.
